(19) Europäisches Patentamt / European Patent Office / Office européen des brevets

(11) **EP 2 921 867 A1**

(12) **DEMANDE DE BREVET EUROPEEN**

(43) Date de publication:
**23.09.2015 Bulletin 2015/39**

(21) Numéro de dépôt: **15151744.8**

(22) Date de dépôt: **20.01.2015**

(51) Int Cl.:
*G01R 21/133* (2006.01)     *G06F 17/10* (2006.01)
*G06Q 50/06* (2012.01)     *G05B 15/02* (2006.01)
*G06K 9/00* (2006.01)     *G01D 4/00* (2006.01)
*G01R 19/25* (2006.01)

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**

(30) Priorité: **06.02.2014 CH 1562014**

(71) Demandeur: **CSEM Centre Suisse d'Electronique
et de
Microtechnique SA - Recherche et
Développement
2002 Neuchâtel (CH)**

(72) Inventeur: **Arberet, Simon
2000 Neuchâtel (CH)**

(74) Mandataire: **P&TS SA (AG, Ltd.)
Av. J.-J. Rousseau 4
P.O. Box 2848
2001 Neuchâtel (CH)**

(54) **Méthode pour extraire des signaux de puissance électrique d'un signal mélangé alimentant une pluralité d'appareils électriques distincts**

(57)    Méthode pour extraire une pluralité de signaux de puissance électrique à partir d'un signal mélangé de puissance électrique alimentant une pluralité d'appareils électriques distincts, chaque signal de puissance correspondant à l'un des appareils électriques; la méthode comprenant: acquérir (1) le signal mélangé; extraire (2) une portion du signal mélangé; appliquer (3) une décomposition parcimonieuse sur la portion de manière à décomposer la portion en une pluralité d'atomes; appliquer (4) une méthode de classification sur ladite pluralité d'atomes de manière à former des groupe d'atomes; chaque groupe d'atomes correspondant au signal de puissance de l'un des appareils électriques; et extraire (8) chacun des signaux de puissance électrique à partir de l'un des groupes d'atomes. La méthode concerne également l'estimation de la consommation de chacun des appareils électriques à partir du signal de puissance extrait pour chacun des appareils électriques. La méthode permet une reconnaissance plus robuste des signaux des appareils électriques.

Fig. 1

EP 2 921 867 A1

**Description**

Domaine technique

La présente invention concerne une méthode pour extraire une pluralité de signaux de puissance électrique à partir d'un signal mélangé de puissance électrique alimentant une pluralité d'appareils électriques distincts. L'invention concerne également l'estimation de la consommation de chacun des appareils électriques à partir du signal de puissance extrait pour chacun des appareils électriques.

En particulier, la présente invention concerne la gestion de l'énergie électrique, et plus particulièrement l'analyse de la consommation électrique (intensité, puissance, tension) d'un réseau électrique, typiquement un foyer, dans le but de détecter et reconnaitre les différents événements électriques (activation, désactivation), l'identité des appareils qui génèrent ces événements, et finalement être capable d'estimer la consommation de chaque appareil.

Etat de la technique

L'extraction des signaux de consommation de chaque appareil à partir des signaux de la consommation globale d'une maison, est un problème de séparation de sources aveugle (SSA), qui a beaucoup d'applications. Par exemple, à l'aide des signaux sources extraits, on peut facilement calculer la consommation de chaque appareil sur une période de temps donnée, en intégrant simplement la puissance des signaux estimés correspondants. On peut localiser les périodes d'activité des appareils, et même identifier leur signature, c'est-à-dire identifier la marque ou le modèle de l'appareil. On peut découvrir les appareils qui consomment le plus et indiquer à l'utilisateur le type des appareils concernés, leurs périodes d'activation. On peut également fournir à l'utilisateur la courbe de consommation de ces appareils. Il est également possible d'utiliser le résultat de ces algorithmes afin de construire un modèle de prédiction fiable de la consommation électrique du foyer, en modélisant la consommation de chaque appareil à partir de leur consommation individuel. Par exemple, si un utilisateur part en vacances, ou lors de changement de saisons, certains appareils vont arrêter de fonctionner ou changer leur consommation d'une manière spécifique.

L'ensemble des technologies pour l'analyse de la consommation électrique des appareils d'un réseau domestique à partir de la consommation globale repose sur l'acquisition des signaux électriques à une certaine fréquence d'échantillonnage. Plus haute est la fréquence d'échantillonnage, plus complexe sont le dispositif d'acquisition et l'ensemble du système, qui doit également stocker, communiquer et effectuer des calculs sur une grande quantité de données.

Après l'acquisition des données, la seconde étape consiste en la détection des évènements d'activation et de désactivation on/off à partir d'un ensemble de caractéristiques qui ont été calculés sur le signal au niveau de chaque transition, ainsi que l'appariement un à un des évènements, c'est-à-dire la mise en correspondance de chaque évènement *on* avec son élément *off* associé. Cet appariement se fait avec une approche dite de *pattern matching* en utilisant une base de données contenant les signatures typiques de chaque appareil.

Dans le brevet US8275561, la méthode proposée est basée sur la détection des évènements *on/off* et d'une étape de classification non-supervisée (*clustering*). Des caractéristiques différentes sont utilisées dans le but de mettre en correspondance les évènements *on* et *off*, et de classifier les évènements dans leur classe d'appareil. La fréquence d'échantillonnage utilisée est 60 Hz. Une des limitations de cette approche est que l'appariement des évènements *on* et *off* est loin d'être optimal dans le sens où la détection des évènements de transition (*on* ou *off*), est une tâche qui est découplée de la seconde tâche consistant à apparier les évènements *on* avec les évènements *off*. Par conséquent, des erreurs risquent d'apparaitre dans chacune de ces tâches. Ces erreurs pourraient être évitées si un modèle global est utilisé, permettant ainsi de fusionner ces deux étapes en une seule. De plus, le problème d'appariement est un problème de type "NP-complet" (le terme NP-complet faisant référence à Non-deterministic Polynomial-time), qui par conséquent ne peut être résolu de façon optimal dans un temps raisonnable, et par conséquent, doit être résolu à l'aide d'une heuristique. La détection des événements est également problématique car certains événements ont une faible énergie, et certains appareils ont une consommation qui a subi une fluctuation aléatoire (bruit dans la terminologie de traitement du signal). Ainsi, afin de détecter ces évènements de faible énergie et de ne pas les confondre avec le bruit de consommation, un compromis doit être fait. Ce dernier aura pour conséquence de générer des erreurs de type faux-positif et faux-négatif. Une autre limitation de cette méthode est que le système d'acquisition, ainsi que l'ensemble de la chaine d'acquisition, est d'autant plus complexe que la fréquence d'échantillonnage est élevée. Traiter de l'information à une fréquence élevée implique d'avoir des convertisseurs analogique-numérique (CAN) à haute cadence, des mémoires de grande capacité, des systèmes de communication et de stockage de l'information rapides et des modules de calculs performants, qui tous coûtent cher.

Dans la demande de brevet WO2012/101552, une méthode basée sur un échantillonnage à une fréquence élevée, typiquement 10 kHz, est proposée. Afin de réduire la quantité de données traitée, les données échantillonnées sont compressées à l'aide d'une méthode de décomposition parcimonieuse comme une méthode de poursuite adaptative (matching pursuit, MP) et poursuite adaptative orthogonale (orthogonal matching pursuit, OMP). Cependant, cette étape de compression, qui réduit la taille du signal, n'est appliquée qu'après l'étape d'échantillonnage, ce qui ne permet donc pas de faire l'économie d'un CAN à haute cadence, ainsi que d'une mémoire et d'un module de calcul performant et cher.

Dans l'article "Gonçalves, H., Ocneanu, A., Bergès, M., & Fan, R. (2011). Unsupervised disaggregation of appliances using aggregated consumption data. In The 1st KDD Workshop on Data Mining Applications in Sustainability (SustKDD)", les auteurs proposent une approche basée sur la détection des évènements *on/off*, en utilisant comme données d'entrée les signaux de puissance active et réactive. La fréquence d'échantillonnage utilisée est 60 Hz. La classification des évènements en appareils est effectuée en utilisant un algorithme génétique ou un algorithme de clustering hiérarchique. Après l'étape d'identification des clusters, les appareils actifs sont détectés et leur amplitude estimée à l'aide d'un algorithme MP sur les évènements de transition, et à la manière d'une méthode de séparation de sources. Cependant, dans cette approche, un modèle des évènements de transitions est utilisé, par opposition à un modèle plus global du fonctionnement des appareils. Par conséquent, comme nous l'avons mentionné précédemment dans cette section, cette approche est sous-optimale et introduit beaucoup d'erreurs. Notons aussi que les algorithmes génétiques et les algorithmes de clustering hiérarchique, sont complexes, plus particulièrement les algorithmes génétiques qui sont des heuristiques qui n'ont aucune garantie de converger vers la solution optimale, et qui sont généralement utilisées en dernier ressort, lorsque toutes les autres méthodes d'optimisations ont échouées.

Bref résumé de l'invention

La présente invention concerne une méthode pour extraire des signaux de puissance (active et réactive) de différents appareils de consommation électrique (par exemple : réfrigérateur, chauffe-eau, lave-linge, etc.), à partir d'un signal de puissance électrique global d'un réseau, typiquement celui d'un foyer.

La présente invention concerne également une méthode pour extraire une pluralité de signaux de puissance électrique à partir d'un signal mélangé de puissance électrique alimentant une pluralité d'appareils électriques distincts chaque signal de puissance électrique correspondant à l'un des appareils électriques; la méthode comprenant: acquérir le signal mélangé; extraire une portion du signal mélangé; appliquer une décomposition parcimonieuse sur la portion de manière à décomposer la portion en une pluralité d'atomes; et appliquer une méthode de classification sur ladite pluralité d'atomes de manière à former des groupe d'atomes; chaque groupe d'atomes correspondant au signal de puissance de l'un des appareils électriques; chacun des signaux de puissance électrique étant extrait à partir de l'un des groupes d'atomes: la décomposition parcimonieuse étant appliquée avec un dictionnaire d'atomes rectangulaires.

La consommation de chacun des appareils électriques peut être estimée à partir du signal de puissance électrique extrait pour chacun des appareils électriques.

La décomposition parcimonieuse peut être basée sur un algorithme de poursuite adaptative orthogonale. Les atomes de la décomposition parcimonieuse peuvent modéliser conjointement les activations et désactivations des évènements *on/off* de chacun des appareils électriques.

L'algorithme de poursuite adaptative orthogonale peut être généralisé au cas des signaux multicanaux. L'algorithme de poursuite adaptative orthogonale multicanal peut permettre une modélisation plus haut niveau du fonctionnement des appareils électrique que la modélisation des transitions *on/off* de l'état de l'art. Cela permet une reconnaissance plus robuste des signaux des appareils électrique. La différence technique la plus importante de la méthode de décomposition par rapport aux méthodes de l'état de l'art basées sur l'utilisation de l'algorithme de poursuite adaptative orthogonale, est l'utilisation d'un dictionnaire d'atomes de formes rectangulaires pour modéliser conjointement le processus d'activation (*on*) et de désactivation (*off*) des appareils électriques.

Plusieurs caractéristiques additionnelles peuvent être implémentées dans la méthode afin d'en augmenter sa robustesse. Dans un premier exemple de réalisation, la méthode peut comprendre un algorithme pour la décomposition de façon jointe les différents canaux du signal et qui exploite ainsi le fait que les appareils ont leur énergie distribuée d'une façon spécifique entre la puissance active et réactive.

La méthode peut également comprendre une contrainte de positivité pour les canaux correspondant à la puissance active, car effet les appareils électriques du foyer ne produisent pas d'énergie, ce qui implique cette contrainte physique sur les signaux. La méthode peut également comprendre un critère d'arrêt de l'algorithme de décomposition afin de stopper la décomposition juste avant que l'algorithme commence à décomposer le bruit résiduel. Le critère d'arrêt peut être basé sur l'énergie du bruit contenu dans la portion du signal mélangé. La méthode peut également comprendre une procédure de retour en arrière afin de pouvoir revenir à l'itération précédente dans le cas où une mauvaise détection a été faite. La méthode peut également comprendre une analyse de la périodicité, utilisée pour les appareils qui ont une consommation par cycles périodiques (par exemple les réfrigérateurs), qui est basée sur la fonction d'autocorrélation d'une représentation intermédiaire du signal des pics, et une extension aux signaux ayant une périodicité variable en utilisant une méthode de pulse local prédominant (prédominant local pulse, PLP) basée sur une analyse de Fourier.

Dans un mode de réalisation, l'étape de former des groupes d'atomes comprend le calcul d'une valeur de confiance pour chacun des atomes de la pluralité d'atomes, le groupe d'atomes comprenant des atomes ayant une valeur de confiance supérieure à un seuil prédéterminé. La valeur de confiance peut être calculée à partir d'un rapport signal bruit de la portion du signal mélangé.

Dans un autre mode de réalisation, la méthode peut comprendre une étape de détecter et d'extraire des motifs périodiques de la portion du signal mélangé. La méthode peut également comprendre une étape de détecter la période principale des motifs périodiques en utilisant une fonction d'autocorrélation. La méthode peut alors comprendre une étape de déterminer une variabilité de la période principale comprenant la comparaison du signal des pics avec un peigne de Dirac ayant pour période ladite période principale.

Encore dans un autre mode de réalisation, la méthode peut comprendre une étape de détermination de la variabilité de la période à l'aide d'une méthode de pulse local prédominant. La méthode peut également comprendre un critère de continuité sur l'évolution de la périodicité compris dans le suivi de la périodicité.

Brève description des figures

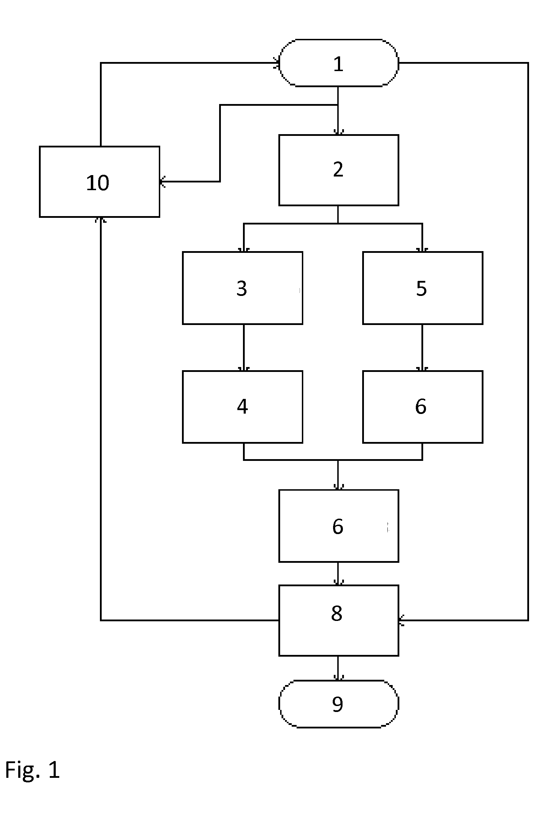

Des exemples de mise en oeuvre de l'invention sont indiqués dans la description illustrée par la figure 1 annexée montrant un diagramme en blocs de la méthode appliqué à un appareil périodique, selon un mode de réalisation.

Exemple(s) de mode de réalisation de l'invention

Dans un mode de réalisation, une méthode pour extraire une pluralité de signaux de puissance électrique à partir d'un signal mélangé de puissance électrique alimentant une pluralité d'appareils électriques distincts, chaque signal de puissance correspondant à l'un des appareils électriques, comprend:

l'acquisition du signal mélangé;

l'extraction d'une portion du signal mélangé;

l'application d'une décomposition parcimonieuse sur la portion de manière à décomposer la portion en une pluralité d'atomes;

l'application d'une méthode de classification sur ladite pluralité d'atomes de manière à former des groupe d'atomes; chaque groupe d'atomes correspondant au signal de puissance de l'un des appareils électriques; et

l'extraction de chacun des signaux de puissance électrique étant extrait à partir de l'un des groupes d'atomes.

Le signal mélangé peut être triphasé d'un foyer et comprenant un courant, une intensité, une puissance et une active et réactive, pour chacune des trois phases. Le signal mélangé peut donc être un signal multicanal composé de six canaux (trois phases, et pour chacune d'elle la puissance active et réactive). Le signal mélangé résulte de l'addition des signaux de puissance de chaque appareil électrique du foyer. Il s'agit donc d'extraire les signaux de chacun de ces appareils à partir de ce signal mélangé. L'acquisition du signal mélangé peut être réalisée à une fréquence d'échantillonnage faible, typiquement 1 Hz. Les données, une fois acquises, sont transmises à une unité de calcul pour l'analyse des signaux avec la méthode décrite ci-dessous.

Chaque signal individuel correspond à un appareil électrique. Un aspect technique principal de l'invention est que la décomposition parcimonieuse est appliquée avec un dictionnaire d'atomes rectangulaires. Les atomes de forme rectangulaire permettent de modéliser conjointement l'activation (on) et la désactivation (off) de chacun des appareils électriques. Les caractéristiques prédéterminées des atomes correspondant à une largeur (durée) et une position temporelle. La hauteur de l'atome étant déterminée de façon à ce que sa norme euclidienne soit égale à un. Le coefficient associé à l'atome et calculé lors de la décomposition du mélange, correspond à la puissance de l'évènement modélisé.

L'estimation de la consommation de chacun des appareils électriques est réalisée à partir du signal de puissance extraite pour chacun des appareils électriques. Ici, la consommation correspond à l'énergie consommée pendant une période de temps (e.g. une journée ou une moyenne sur une année de la consommation d'une journée). Cette estimation de la consommation électrique peut être simplement calculée en intégrant chacun des signaux de puissance sur la période de temps correspondante.

De manière préférée, la décomposition parcimonieuse est basée sur une poursuite adaptative orthogonale. L'algorithme de poursuite adaptative et son extension consistent à trouver itérativement dans un dictionnaire l'élément (vecteur) le plus corrélé avec le signal, d'ôter la contribution de ce vecteur au signal et de recommencer le processus jusqu'à obtention d'un nombre d'éléments (atomes) égal à la dimension du signal.

En particulier, la poursuite adaptative est un algorithme itératif qui minimise l'erreur de reconstruction $\|f - D_x\|2$ avec une contrainte de parcimonie sur la décomposition des coefficients $x$, ce qui signifie que la plupart des coefficients du vecteur x ont une valeur nulle. La poursuite adaptative est un algorithme de type « glouton » offre de bonnes propriétés de décroissance de l'erreur entre le signal original et le signal parcimonieux. A chaque itération $k$ de l'algorithme, un atome du dictionnaire D est sélectionné et sa contribution est soustraite du résidu

$$R^{(k)} = f - Dx^{(k)}.$$

Dans l'algorithme de poursuite adaptative, l'atome sectionné est celui qui est le plus corrélé avec le résidu à l'itération courante.

Comme dans notre problème, la plupart des appareils ont un comportement à deux états *on* ou *off*. Les atomes de ce dictionnaire ont des formes rectangulaires, avec différentes tailles afin de pouvoir capturer les différentes durées possibles de chaque d'activation. De façon plus formelle, chaque atome du dictionnaire est constant sur son support qui est un segment (au sens mathématique).

Dans un mode de réalisation, le dictionnaire est invariant par translation, ce qui signifie que toutes les versions translatées de chaque atome (rectangulaire) sont présentes dans le dictionnaire afin de pouvoir traiter les évènements de la même façon, quels que soient leur position. Notons que cette propriété d'invariance par translation, peut être implémenté de façon efficace, sans avoir à dupliquer naïvement les atomes à toutes les positions possibles, en utilisant un algorithme de convolution rapide basée sur la transformé de Fourier rapide (TFR, ou FFT en anglais).

Chacun des signaux individuels est triphasé. Chaque phase comprend une puissance active et réactive, et la poursuite adaptative orthogonale comprend une contrainte de positivité sur au moins un canal correspondant à l'une des phases comprenant une puissance active ou réactive. L'algorithme de poursuite adaptative orthogonale, ou l'algorithme de poursuite adaptative, est sa version généralisée [Gribonval, Rémi. "Piecewise linear source séparation." Optical Science and Technology, SPIE's 48th Annual Meeting. International Society for Optics and Photonics, 2003] au cas des signaux multicanaux, ce qui permet d'exploiter au maximum la corrélation entre les canaux. Dans notre cas, cette extension nous permet d'exploiter le fait que chaque appareil à son signal de puissance qui est répartie de manière spécifique entre la puissance active et réactive. Comme les signaux de puissance sont multicanaux (3 phases avec puissance active et réactive pour chacune des phases), nous utilisons un algorithme de poursuite adaptative orthogonale multicanal qui prend en compte des contraintes telles que la positivité de la puissance active.

Les algorithmes de poursuite adaptative et de poursuite adaptative orthogonale sont des algorithmes itératifs, et par conséquent un critère d'arrêt doit être défini afin de décider quand l'algorithme doit s'arrêter.

Si l'on connait l'énergie moyenne du bruit ou si l'on a une borne maximale sur son amplitude, on peut décider d'arrêter l'algorithme quand l'énergie (au sens du signal, c'est-à-dire la norme euclidienne L2) du résidu $R^{(k)}$ devient inférieure à cette borne. On peut aussi décider d'arrêter l'algorithme quand l'énergie relative de la variation de l'erreur résiduelle est inférieure à un seuil, c'est-à-dire quand:

$$\left\| R^{(k)} - R^{(k-1)} \right\|2 \, / \, \left\| R^{(k)} \right\|2 \; < \; \eta.$$

De façon préférée, un critère d'arrêt basé sur l'énergie du bruit est utilisé car il est plus facile d'avoir une idée grossière du niveau de bruit que l'on peut s'attendre à avoir dans un contexte donné.

Dans certaines circonstances, un critère basé sur la forme de l'évolution de l'erreur résiduelle $\|R^{(k)}\|2$ en fonction des itérations $k$ peut être utilisé. Comme cette fonction est sensée décroître de façon exponentielle, il est possible de détecter, après un certain nombre d'itérations, s'il y a un point d'inflexion qui indique qu'il y a probablement sur-décomposition. Seuls les atomes situés avant le point d'inflexion sont alors conservés, les suivant étant ignorés.

La classification, c'est-à-dire la formation d'un groupe d'atomes par une méthode de classification, également appelée "partitionnement de données" ou encore "clustering" en anglais, peut être effectuée par une méthode classification non supervisée une fois que la décomposition de la poursuite adaptative orthogonale est faite. La formation d'un groupe d'atomes comprend l'identification des groupes d'atomes parmi les atomes de la décomposition, à l'aide d'un algorithme de clustering. Le but étant d'identifier une forme correspondant à la portion de signal que l'on cherche à extraire. Comme il y a plus de chance d'obtenir une décomposition contenant des erreurs dans les régions où de multiples sources (i.e. appareils) sont actives simultanément, le clustering n'est pas réalisé sur l'ensemble des atomes de la décomposition. Le clustering est plutôt réalisé sur une sélection d'atomes isolés et considérés comme suffisamment fiables. Une valeur dite de confiance pour chaque atome est ensuite calculée. Cette valeur de confiance est une sorte de rapport signal à bruit (RSB) mesurant le rapport entre l'énergie (au sens du signal) de l'atome courant et l'énergie des atomes qui interfèrent avec l'atome courant (c'est-à-dire pour lesquels les supports se superposent avec l'atome courant).

La classification peut également être supervisée, c'est-à-dire telle que les règles de formation des groupes d'atomes (ou classes d'appareils) sont établies à partir d'une base de donnée d'apprentissage. Cette base de données est constituée à partir d'exemples de signaux de chaque classe d'appareils qui peuvent avoir été acquis par l'utilisateur (le système peut par exemple demander à l'utilisateur d'activer un seul appareil pendant une période de temps) ou par le fournisseur de la méthode. Cette approche peut être utile notamment pour introduire de nouveaux appareils par apprentissage, c'est-à-dire sans avoir à reprogrammer la méthode.

Le clustering est alors effectué seulement sur les atomes ayant une valeur de confiance supérieure à un seuil prédéterminé. Les atomes ayant des caractéristiques similaires (longueur du support, puissance active, puissance réactive) sont alors regroupés en utilisant un algorithme ad-hoc de clustering.

Dans un mode de réalisation, la méthode comprend une étape de détecter et d'extraire des motifs périodiques de la portion du signal mélangé. L'extraction des motifs peut être réalisée par l'extraction de pics de la portion de signal l'aide d'une méthode basée sur le seuillage des dérivées première et seconde. Le signal constitué des pics extraits est ensuite lissé à l'aide d'un noyau gaussien, le but étant de permettre une certaine tolérance sur la position des pics, sachant que les motifs périodiques recherchés ne sont pas rigoureusement périodiques. Cette version lissée du signal des pics, utilisé pour détecter un motif périodique, est appelé « fonction de détection » (FD).

Encore dans un mode de réalisation, la méthode comprend une étape de détecter la période principale des motifs périodiques dont la période est constante. La détection peut être réalisée en utilisant une fonction d'autocorrélation, c'est-à-dire, par la détection le pic principal de la fonction d'autocorrélation de la FD. La position de ce pic nous donne alors la valeur de la période (en nombre d'échantillons) du motif périodique. Une des difficultés de cette approche est de détecter le « bon » pic, puisque plusieurs pics peuvent apparaître dans la fonction d'autocorrélation, principalement à cause de l'existence de sous-harmoniques (multiples de la période), et aussi d'autres motifs périodiques de la DF qui peuvent venir interférer. Le « bon » pic est un pic qui doit être à la fois grand en amplitude, et avoir sa position proche de zéro. Pour cette raison, le pic sélectionné est le premier pic ayant son amplitude supérieure à un seuil qui a pour valeur 25% de l'énergie totale de la FD. Afin de régler la taille du noyau de façon automatique et adaptative, une heuristique basée sur la forme de la fonction d'autocorrélation peut être utilisée.

Une fois la période estimée et afin d'identifier les pics impliqués dans le motif périodique, le signal des pics peut être comparé avec un peigne de Dirac ayant pour période la période principale détectée. Cette procédure permet de vérifier si les pics identifiés ont une période constante, dans quel cas ils seront précisément alignés avec le peigne de Dirac. Si ce n'est pas le cas, cela signifie qu'il y a probablement une évolution de la période du motif. Afin de pouvoir suivre l'évolution de cette période, une méthode de pulse local prédominant (prédominant local pulse, PLP) peut être utilisée.

La méthode de pulse local prédominant, qui a été proposée dans le contexte du suivi de la pulsation dans les enregistrements musicaux, consiste à faire correspondre à chaque instant, un noyau sinusoïdal qui soit au maximum corrélé avec la nature périodique du signal (la FD dans notre cas), et ensuite d'employer une technique d'*overlapp-add* afin d'accumuler tous ces noyaux au fur et à mesure. La période principale (un tempo dans le contexte musical) n'est pas nécessairement constante dans le temps. En fait, la fonction de pulse local prédominant contient une information de périodicité (tempo) pour chaque position temporelle.

La fonction de pulse local prédominant s'obtient en calculant les coefficients de Fourier locaux:

$$F(w, t) = \sum_n DF(n) \cdot W(n - t) \cdot e^{-2\pi i w n}$$

pour chaque échantillon temporel t et pour chaque intervalle de fréquences correspondant à l'intervalle des périodes (tempos) qui est recherché. Le tempogramme est une représentation du tempo en fonction du temps qui peut être obtenue à partir d'un spectrogramme en remplaçant l'axe des fréquences par une valeur de tempo en PPM (pulsations par minute) au lieu de la valeur en Hz. Cette représentation graphique est utile pour observer les variations de tempo au cours du temps. La fréquence $w_t$ du noyau

$$\kappa_t(n) = W(n - t) \cos\big(2\pi(w_t n - \varphi_t)\big)$$

à l'échantillon *t*, est la valeur max de la magnitude du spectrogramme

$$w_t = argmax_w |F(w, t)|.$$

La période à chaque instant temporel est donc $1/w_t$. Afin d'éviter des écarts importants de fréquences entre deux échantillons consécutifs, une pénalité L2 peut être ajoutée sur le terme de variation de fréquences :

$$w_t = argmax_w |F(w, t) - \lambda |w - w_{t-1}|^2|.$$

Finalement, la PLP est défini comme l'accumulation de toutes les parties positives des noyaux:

$$\Gamma(n) = \sum_t max(\kappa_t(n), 0).$$

La fonction de pulse local prédominant présente des protubérances positives aux endroits où se situent les pics du motif périodique, et nous pouvons alors utiliser la position de ces protubérances pour identifier les pics impliqués dans ce motif périodique.

Pour illustrer d'avantage l'invention, l'exemple suivant est décrit et illustré à la figure 1, sans intention de limiter la portée de l'invention.

L'algorithme consiste à, premièrement extraire 2 la portion du signal à partir d'un signal mélangé 1 sur lequel le signal d'un appareil est présenté. L'algorithme fonctionnera probablement mieux si sur cette portion, les signaux des autres appareils n'ont pas une énergie importante comparée à celle du signal que l'on cherche à extraire. Dans le cas des réfrigérateurs qui ont une consommation d'énergie moyenne quasi constante, on a alors intérêt à choisir une portion du signal où le mélange a une énergie la plus faible possible. La taille de cette portion ne doit pas être trop grande (typiquement une durée de quatre heures), de façon à ce que le calcul de la décomposition par l'algorithme de poursuite adaptative orthogonale, qui a une complexité en $O(n^2 \log(n))$, puisse être exécuté rapidement. Une autre façon de réduire le temps calcul est de décimer le signal (c'est-à-dire réduire sa fréquence d'échantillonnage), par typiquement un facteur dix, ce qui a pour effet d'accélérer l'algorithme d'un facteur d'environ 100.

Une fois que la décomposition 3 de poursuite adaptative orthogonale a été faite, l'étape suivante consiste à former un groupe d'atomes 4 comme décrit ci-dessus.

Si un pic au début de chaque cycle d'activation est présent, comme c'est le cas pour les signaux d'un réfrigérateur, cet a priori peut être exploité en extrayant 5 les pics de la portion de signal et en détectant le motif périodique principal 6 du signal de pics comme décrit ci-dessus. Une fois le motif périodique principal extrait, il est possible de vérifier que les atomes sélectionnés par l'algorithme de poursuite adaptative orthogonale correspondent aux pics du motif périodique 7 (autrement dit, un pic doit être synchronisé avec le début du cycle), ce qui correspond à l'a priori pour les signaux des réfrigérateurs. Le signal de l'appareil est ensuite extrait 8 à l'aide de l'algorithme de poursuite adaptative orthogonale appliqué à un petit segment autour de chaque pic du motif périodique.

Finalement, s'il y a d'autres appareils dans la portion de signal, le signal estimé 9 du premier appareil peut être soustrait 10 de la portion de signal et la procédure peut être recommencés une nouvelle fois.

## Revendications

1. Méthode pour extraire une pluralité de signaux de puissance électrique à partir d'un signal mélangé de puissance électrique alimentant une pluralité d'appareils électriques distincts, chaque signal de puissance correspondant à l'un des appareils électriques; la méthode comprenant:

   acquérir le signal mélangé;
   extraire une portion du signal mélangé; et
   appliquer une décomposition parcimonieuse sur la portion de manière à décomposer la portion en une pluralité d'atomes;
   **caractérisée en ce que**
   la méthode comprend également l'application d'une méthode de classification sur ladite pluralité d'atomes de manière à former des groupe d'atomes, chaque groupe d'atomes correspondant au signal de puissance de l'un des appareils électriques;
chacun des signaux de puissance électrique étant extrait à partir de l'un des groupes d'atomes; et
la décomposition parcimonieuse est appliquée avec un dictionnaire d'atomes rectangulaires.

2. Méthode selon la revendication 1,
   dans laquelle la décomposition parcimonieuse est basée sur un algorithme de poursuite adaptative orthogonale.

3. Méthode selon la revendication 1 ou 2,
   dans laquelle les atomes de la décomposition parcimonieuse modélisent conjointement l'activation et la désactivation des évènements de chacun des appareils électriques.

4. Méthode selon l'une des revendications 1 à 3,
   dans laquelle chacun des atomes rectangulaires est **caractérisé par** une largeur et une position temporelle, la hauteur de l'atome étant déterminée de façon à ce que sa norme euclidienne soit égale à un, et le coefficient associé à l'atome correspondant à une puissance d'un évènement modélisé.

5. Méthode selon l'une des revendications 1 à 4,
   dans laquelle la méthode de classification est supervisée ou non supervisée.

6. Méthode selon l'une des revendications 2 à 5,
   dans laquelle l'algorithme de poursuite adaptative orthogonale est sa version généralisée au cas des signaux multicanaux.

7. Méthode selon l'une des revendications 1 à 6,
   dans laquelle chacun des signaux de puissance est triphasé, chaque phase comprenant une puissance active et réactive, et la poursuite adaptative orthogonale comprend une contrainte de positivité sur au moins un canal correspondant à la puissance active de l'une des phases.

8. Méthode selon l'une des revendications 1 à 7,
   dans laquelle, lors de l'acquisition, le signal mélangé est échantillonné à une fréquence constante, préférablement à environ 1 Hz.

9. Méthode selon l'une des revendications 1 à 8,
   dans laquelle l'étape de former des groupes d'atomes comprend le calcul d'une valeur de confiance pour chacun des atomes de la pluralité d'atomes, le groupe d'atomes comprenant des atomes ayant une valeur de confiance supérieure à un seuil prédéterminé.

10. Méthode selon l'une des revendications 1 à 9,

dans laquelle le dictionnaire d'atomes rectangulaires est invariant par translation.

**11.** Méthode selon l'une des revendications 1 à 10, comprenant en outre une étape de détecter et d'extraire des motifs périodiques de la portion du signal mélangé.

**12.** Méthode selon la revendication 11, comprenant en outre une étape de détecter la période principale des motifs périodiques en utilisant une fonction d'autocorrélation.

**13.** Méthode selon la revendication 12, comprenant en outre une étape de déterminer une variabilité de la période principale comprenant la comparaison du signal des pics avec un peigne de Dirac ayant pour période ladite période principale.

**14.** Méthode selon la revendication 13, comprenant en outre une étape de détermination de la variabilité de la période à l'aide d'une méthode de pulse local prédominant.

**15.** Méthode selon l'une des revendications 1 à 14, dans laquelle la décomposition parcimonieuse comprend un critère d'arrêt, le critère d'arrêt étant basé sur l'énergie du bruit contenu dans la portion du signal mélangé.

**16.** Méthode selon l'une des revendications 1 à 15 comprenant en outre l'estimation de la consommation de chacun des appareils électriques à partir du signal de puissance électrique extrait pour chacun des appareils électriques.

Fig. 1

Europäisches
Patentamt

European
Patent Office

Office européen
des brevets

**RAPPORT DE RECHERCHE EUROPEENNE**

Numéro de la demande

EP 15 15 1744

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | MARISA FIGUEIREDO ET AL: "On the Regularization Parameter Selection for Sparse Code Learning in Electrical Source Separation", 4 avril 2013 (2013-04-04), ADAPTIVE AND NATURAL COMPUTING ALGORITHMS, SPRINGER BERLIN HEIDELBERG, BERLIN, HEIDELBERG, PAGE(S) 277 - 286, XP047027692, ISBN: 978-3-642-37212-4 * le document en entier * ----- | 1 | INV. G01R21/133 G06F17/10 G06Q50/06 G05B15/02 G06K9/00 G01D4/00 ADD. G01R19/25 |
| Y | RON RUBINSTEIN ET AL: "Dictionaries for Sparse Representation Modeling", PROCEEDINGS OF THE IEEE, IEEE. NEW YORK, US, vol. 98, no. 6, 1 juin 2010 (2010-06-01), pages 1045-1057, XP011307903, ISSN: 0018-9219 * le document en entier * ----- | 1 | |
| Y | FIGUEIREDO MARISA ET AL: "Electrical Signal Source Separation Via Nonnegative Tensor Factorization Using On Site Measurements in a Smart Home", IEEE TRANSACTIONS ON INSTRUMENTATION AND MEASUREMENT, IEEE SERVICE CENTER, PISCATAWAY, NJ, US, vol. 63, no. 2, 1 février 2014 (2014-02-01), pages 364-373, XP011535861, ISSN: 0018-9456, DOI: 10.1109/TIM.2013.2278596 [extrait le 2014-01-01] * le document en entier * ----- -/-- | 1 | **DOMAINES TECHNIQUES RECHERCHES (IPC)** G01R G06F G06Q G05B G06K G01D |

Le présent rapport a été établi pour toutes les revendications

| Lieu de la recherche | Date d'achèvement de la recherche | Examinateur |
|---|---|---|
| Munich | 13 août 2015 | Hijazi, Ali |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

...........................................................................
& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 15 15 1744

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | Marisa Batalha ET AL: "Contributions to Electrical Energy Disaggregation in a Smart Home", , 1 septembre 2013 (2013-09-01), XP055133488, Extrait de l'Internet: URL:https://www.cisuc.uc.pt/publication/showfile?fn=1398791801_PhDThesis-MarisaFigueiredo.pdf [extrait le 2014-08-06] * page 115 - page 158 * ----- | 1 | |
| A | US 2013/289788 A1 (GUPTA ABHAY [US] ET AL) 31 octobre 2013 (2013-10-31) * alinéa [0064] - alinéa [0071]; figure 7 * ----- | 1-16 | |
| X,P | ARBERET SIMON ET AL: "Non-intrusive load curve disaggregation using sparse decomposition with a translation-invariant boxcar dictionary", IEEE PES INNOVATIVE SMART GRID TECHNOLOGIES, EUROPE, IEEE, 12 octobre 2014 (2014-10-12), pages 1-6, XP032730754, DOI: 10.1109/ISGTEUROPE.2014.7028915 [extrait le 2015-01-30] * le document en entier * ----- -/-- | 1 | **DOMAINES TECHNIQUES RECHERCHES (IPC)** |

Le présent rapport a été établi pour toutes les revendications

| Lieu de la recherche | Date d'achèvement de la recherche | Examinateur |
|---|---|---|
| Munich | 13 août 2015 | Hijazi, Ali |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

........................................................................................

& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 15 15 1744

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | Hugo Gonçalves ET AL: "Unsupervised disaggregation of appliances using aggregated consumption data", 21 août 2011 (2011-08-21), XP055133329, The 17th ACM SIGKDD Conference on Knowledge Discovery and Data Mining Extrait de l'Internet: URL:http://users.cis.fiu.edu/~lzhen001/activities/KDD2011Program/workshops/WKS10/doc/SustKDD2.pdf [extrait le 2014-08-05] * le document en entier * ----- | 1 | |
| A,D | US 2010/287489 A1 (ALLES HAROLD GENE [US]) 11 novembre 2010 (2010-11-11) * abrégé * ----- | 1 | |
| A,D | Hugo Gonçalves ET AL: "Unsupervised disaggregation of appliances using aggregated consumption data", 21 août 2011 (2011-08-21), XP055133237, The 17th ACM SIGKDD - Conference on Knowledge Discovery and Data Mining Extrait de l'Internet: URL:http://users.cis.fiu.edu/~lzhen001/activities/KDD2011Program/workshops/WKS10/doc/SustKDD2.pdf [extrait le 2014-08-05] * abrégé * ----- -/-- | 1 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 13 août 2015 | Hijazi, Ali |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 15 15 1744

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A,D | REMI GRIBONVAL: "<title>Piecewise linear source separation</title>", PROCEEDINGS OF SPIE, vol. 5207, 13 novembre 2003 (2003-11-13), pages 297-310, XP055133310, ISSN: 0277-786X, DOI: 10.1117/12.504790 * abrégé * | 1 | |
| A,D | WO 2012/101552 A2 (KONINKL PHILIPS ELECTRONICS NV [NL]; WANG YING [NL]; FILIPPI ALESSIO []) 2 août 2012 (2012-08-02) * abrégé * | 1 | |
| A | Rémi Gribonval: "Sur quelques problèmes mathématiques de modélisation parcimonieuse.", Habilitation à diriger des recherches. Antoine Follain (17 décembre 2002), 24 octobre 2007 (2007-10-24), pages 1-95, XP055133562, Extrait de l'Internet: URL:http://www.persee.fr/web/revues/home/p rescript/article/annor_0003-4134_2005_num_ 55_1_1521 [extrait le 2014-08-06] * le document en entier * ----- | 1 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 13 août 2015 | Hijazi, Ali |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

&: membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 15 15 1744

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

13-08-2015

| Document brevet cité au rapport de recherche | Date de publication | Membre(s) de la famille de brevet(s) | | Date de publication |
|---|---|---|---|---|
| US 2013289788    A1 | 31-10-2013 | AU | 2013251524 A1 | 04-12-2014 |
| | | CA | 2871616 A1 | 31-10-2013 |
| | | EP | 2842011 A1 | 04-03-2015 |
| | | US | 2013289788 A1 | 31-10-2013 |
| | | WO | 2013163460 A1 | 31-10-2013 |
| US 2010287489    A1 | 11-11-2010 | AUCUN | | |
| WO 2012101552    A2 | 02-08-2012 | AUCUN | | |

EPO FORM P0460

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8275561 B

- WO 2012101552 A

**Littérature non-brevet citée dans la description**

- **GONÇALVES, H., OCNEANU, A. ; BERGÈS, M. ; FAN, R.** Unsupervised disaggregation of appliances using aggregated consumption data. *The 1st KDD Workshop on Data Mining Applications in Sustainability (SustKDD),* 2011

- Piecewise linear source séparation. **GRIBONVAL, RÉMI.** Optical Science and Technology, SPIE's 48th Annual Meeting. International Society for Optics and Photonics, 2003